(19) Europäisches Patentamt
European Patent Office
Office européen des brevets

(11) **EP 3 761 042 B1**

(12) **EUROPEAN PATENT SPECIFICATION**

(45) Date of publication and mention
of the grant of the patent:
**15.05.2024  Bulletin 2024/20**

(21) Application number: **18908082.3**

(22) Date of filing: **28.02.2018**

(51) International Patent Classification (IPC):
**G01R 15/18** $^{(2006.01)}$   **G01R 19/00** $^{(2006.01)}$

(52) Cooperative Patent Classification (CPC):
**G01R 15/181**

(86) International application number:
**PCT/JP2018/007623**

(87) International publication number:
**WO 2019/167189 (06.09.2019 Gazette 2019/36)**

(54) **ROGOWSKI COIL AND CURRENT MEASURING DEVICE USING SAME**

ROGOWSKI-SPULE UND STROMMESSVORRICHTUNG DAMIT

BOBINE DE ROGOWSKI ET DISPOSITIF DE MESURE DU COURANT UTILISANT CELLE-CI

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**06.01.2021  Bulletin 2021/01**

(73) Proprietor: **Iwatsu Electric Co., Ltd.**
**Tokyo 168-8501 (JP)**

(72) Inventors:
• **DEGAWA, Sakae**
  **Tokyo 168-8501 (JP)**
• **ICHINOSE, Takahito**
  **Tokyo 168-8501 (JP)**

(74) Representative: **Patentanwälte**
**Ruff, Wilhelm, Beier, Dauster & Partner mbB**
**Kronenstraße 30**
**70174 Stuttgart (DE)**

(56) References cited:
EP-A1- 1 073 908     WO-A1-03/073118
JP-A- 2005 109 398    JP-A- 2014 089 079
JP-A- 2017 504 022    US-B1- 6 614 218

• J Cooper: "ON THE HIGH-FREQUENCY RESPONSE OF A ROGOWSKI COIL", J. Nucl. Energy, Pt. C, 1 September 1963 (1963-09-01), pages 285-289, XP055174899, DOI: 10.1088/0368-3281/5/5/302 Retrieved from the Internet: URL:http://www.osti.gov/energycitations/product.biblio.jsp?osti_id=4695606
• BAOCHENG WANG ET AL: "A Rogowski coil current transducer designed for wide bandwidth current pulse measurement", IEEE 6TH INTERNATIONAL POWER ELECTRONICS AND MOTION CONTROL CONFERENCE, 2009 : IPEMC '09 ; WUHAN, CHINA, 17 - 20 MAY 2009, IEEE, PISCATAWAY, NJ, USA, 17 May 2009 (2009-05-17), pages 1246-1249, XP031535297, DOI: 10.1109/IPEMC.2009.5157575 ISBN: 978-1-4244-3556-2
• RAY W F ET AL: "HIGH FREQUENCY IMPROVEMENTS IN WIDE BANDWIDTH ROGOWSKI CURRENT TRANSDUCERS", 8TH EUROPEAN CONFERENCE ON POWER ELECTRONICS AND APPLICATIONS. LAUSANNE, CH, SEPT. 7 - 9, 1999; [EPE . EUROPEAN CONFERENCE ON POWER ELECTRONICS AND APPLICATIONS], EPE ASSOCIATION, BRUSSELS, BE, vol. CONF. 8, 7 September 1999 (1999-09-07), pages 1-09, XP001121319, ISBN: 978-90-75815-04-7

EP 3 761 042 B1

## Description

The present invention relates to a Rogowski coil according to the preamble of claim 1, and to a current measuring device using the same.

A current measuring device using a Rogowski coil is known as a non-contact type current measuring device that measures currents by using an induced voltage that is induced by magnetic fields generated by the current to be measured changing with time. Since the Rogowski coil does not have a magnetic core, the magnetic flux penetrating the coil does not saturate, and therefore the Rogowski coil has the advantage that it can measure a large current. Therefore, the Rogowski coil is suitable for applications in the field of power electronics for measuring a large current flowing through a power device.

Rogowski coils are used for measuring currents in various fields, and one of the main applications is measuring high-speed and large-current switching waveforms in the field of power electronics. Since the switching speed of the devices has been increased with recent development of switching devices, and the current to be measured is getting faster, there is an increasing demand for wider frequency band for current sensors.

For example, laid-open publication EP 1 073 908 A1 (hereafter, referred to as EP1073908) and parallel US 6,614,218 B1 describe a current measuring device comprising a Rogowski coil according to the preamble of claim 1, and more specifically describe an integrator that is connected to the subsequent stage of the Rogowski coil configured to combine a first integrator excellent in high frequency characteristics and a second integrator excellent in low frequency characteristics, so as to widen the frequency band of measurable currents. In addition, EP1073908 describes widening the frequency band of measurable currents by arranging a damping resistor matched with the characteristic impedance of the Rogowski coil between the Rogowski coil and the integrator and suppressing oscillation of the integrator in the high frequency region. The Rogowski coil is connected at its output end to a coaxial cable leading to an electronic integrator, where a first part of a passive integrator is arranged at the coil-facing end of the cable and includes a resistor network to match a coil terminating resistance with a coil characteristic impedance, and a second part of the passive integrator is arranged at the other end of the cable and may include a resistor for matching with a characteristic impedance of the coaxial cable.

With recent development of technology in the field of power electronics, the switching speed of power devices has become faster. However, the technique described in EP1073908 has a problem that the frequency band of measurable currents is insufficient and the frequency band varies depending on the installation condition of the coil, resulting in unstable current measurement. Therefore, there is a demand for a Rogowski coil capable of stably measuring higher frequency large currents.

J. Cooper, "On the High-Frequency Response of a Rogowski Coil", J. Nucl. Energy, Pt. C, 1 Sept. 1963, p. 285 discusses some results of a theoretical analysis of specific Rogowski coil arrangements in particular regarding transit high-frequency response time effects for various coil termination configurations.

It is the technical problem underlying the present invention to provide a Rogowski coil capable of stably measuring currents with wider frequency band regardless of the installation condition of the coil, and a current measuring device using the same.

The present invention solves this problem by providing a Rogowski coil with the features of claim 1. According to one aspect of the present invention, the Rogowski coil comprises a coil formed by winding a wire in a solenoid shape; a return line penetrating the inside of the coil from a tip portion, which is one end of the coil, to an output end, which is the other end of the coil; and an impedance matching circuit connected between the tip portion of the coil and the return line, having an impedance matched with the characteristic impedance of the coil, wherein the coil and the return line are electrically connected at the tip portion of the coil via the impedance matching circuit.

According to another aspect of the present invention, a current measuring device is provided according to claim 7 which comprises: the above Rogowski coil, wherein the coil is arranged to form a loop around a conductor through which the current to be measured flows; and an integrator configured to integrate with time the potential difference that is induced by the current to be measured changing with time between the output end of the coil and the return line, and outputs the measured value as the current to be measured, is provided.

According to the present invention, a Rogowski coil capable of stably measuring currents with wider frequency band regardless of the installation condition of the coil, and a current measuring device using the same, are provided.

Advantageous embodiments of the invention are shown in the drawings together with comparative examples for better understanding the invention and are described in the following. In the drawings:

FIG. 1 is a diagram schematically illustrating a configuration of a Rogowski coil according to a first embodiment.
FIG. 2 is an equivalent circuit schematically illustrating a configuration of a current measuring device according to the first embodiment.
FIG. 3 is a diagram illustrating a propagation delay of the induced voltage that is induced in the Rogowski coil, which is a comparative example.
FIG. 4 is a diagram illustrating changes of the output voltage of the Rogowski coil when the relative position between the Rogowski coil and the current to be measured is varied, which is a comparative example.

FIG. 5 is a first diagram illustrating a change of the output voltage of the Rogowski coil according to the first embodiment when the relative position between the Rogowski coil and the current to be measured is varied.

FIG. 6 is a second diagram illustrating a change of the output voltage of the Rogowski coil according to the first embodiment when the relative position between the Rogowski coil and the current to be measured is varied.

FIG. 7 is a third diagram illustrating a change of the output voltage of the Rogowski coil according to the first embodiment when the relative position between the Rogowski coil and the current to be measured is varied.

FIG. 8 is a diagram schematically illustrating a configuration of a Rogowski coil according to a second embodiment.

FIG. 9 is a diagram schematically illustrating a configuration of a Rogowski coil according to a third embodiment.

FIG. 10 is a diagram schematically illustrating another configuration of a Rogowski coil according to the third embodiment.

Preferred embodiments of the present invention will be described below with reference to the drawings. Note that the present invention is not limited to the following embodiments, but may be appropriately modified without departing from the gist thereof. In the drawings, components having the same or similar functions are assigned the same reference numerals, and descriptions thereof may be omitted or simplified.

There are two major factors that limit widening of the bandwidth of current measuring devices that use a Rogowski coil. The first factor is due to the performance of the integrator connected to the subsequent stage of the Rogowski coil. The invention described in the above EP1073908 intends to solve this first factor.

The second factor is due to the structure of the Rogowski coil itself. A study on what limit wide band operation due to the structure of the Rogowski coil itself has revealed that, when the coil is viewed as a transmission line, the propagation delay time is a major factor. The inventor of the present invention has discovered that, when an induced voltage waveform induced in the coil was reflected at the tip portion of the coil and overlapped with the original induced voltage waveform with a time difference due to propagation delay, the output voltage waveform of the Rogowski coil spreads.

Since the spread of the output voltage waveform of the Rogowski coil limits the response frequency band of the Rogowski coil, there is a first problem that, when this spread of the waveform becomes about the same as the period of the current to be measured or its transient change time, the frequency band of the current measurement system becomes insufficient, and the measurement accuracy of the Rogowski coil decreases.

In addition, the spread of the output voltage waveform of the Rogowski coil due to the propagation delay of the induced voltage varies depending on the relative position between the Rogowski coil and the current to be measured. For this reason, there is a second problem that the measurement result of currents in high frequency region varies depending on the installation condition such as the physical position of the coil, and is not stable. This second problem practically limits the frequency band of currents measurable by the Rogowski coil as well.

Therefore, the Rogowski coil of the present invention comprises an impedance matching circuit connected between the tip portion of the coil and a return line. The impedance matching circuit has an impedance matched with the characteristic impedance of the coil. According to such a configuration of the Rogowski coil, signal reflections at the tip portion of the coil can be suppressed. As a result, since the output voltage waveform of the Rogowski coil is suppressed from spreading due to the influence of signal reflections, the frequency band of currents measurable by the Rogowski coil is widened, and the Rogowski coil can measure currents stably regardless of the installation condition of the coil.

(First Embodiment)

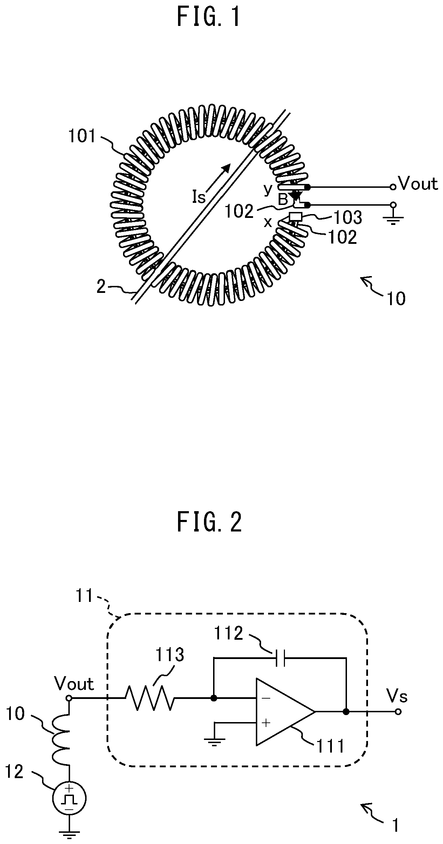

FIG. 1 is a diagram schematically illustrating a configuration of a Rogowski coil 10 according to a first embodiment. The Rogowski coil 10 of the present embodiment comprises a coil 101, a return line 102, and an impedance matching circuit 103.

As illustrated in FIG. 1, the coil 101 has a structure in which a conductor wire is wound in a solenoid shape, and is arranged to form a loop around the conductor 2 through which currents to be measured Is flows. Since the Rogowski coil 10 is constituted by an air-core coil without magnetic core, the inside of the coil 101 is hollow. Note that the coil 101 may have a non-magnetic core portion (not illustrated) inside the coil 101 for winding the conductive wire.

The return line 102 penetrates the inside of the coil 101 from a tip portion x, which is one end of the coil 101, to an output end y, which is the other end of the coil 101. One end of the return line 102 is connected to the tip portion x of the coil 101 via the impedance matching circuit 103. The other end of the return line 102 is grounded via a ground terminal.

The impedance matching circuit 103 is connected between the tip portion x of the coil 101 and the return line 102. The impedance matching circuit 103 has an impedance matched with the characteristic impedance of the coil 101. In other words, the impedance matching circuit 103 has substantially the same impedance as the characteristic impedance of the coil 101. Here, "substantially the same" in the present embodiment means that the impedances are the same sufficient to suppress signal reflections at the boundary between the tip portion x of the coil 101 and the return line 102.

A resistance element, for example, is used as the impedance matching circuit 103. The impedance matching circuit 103 may comprise not only a resistance element but also a circuit element such as an inductance or a capacitance. According to such a configuration of the Rogowski coil 10, signal reflections at the boundary between the tip portion x of the coil 101 and the return line 102 can be suppressed. As a result, since the output voltage waveform of the Rogowski coil 10 is suppressed from spreading due to the influence of signal reflections, the frequency band of currents measurable by the Rogowski coil 10 is widened, and the Rogowski coil 10 can measure currents stably regardless of the installation condition of the coil 101.

A potential difference is generated between the tip portion x and the output end y of the coil 101, based on an induced voltage proportional to the change with time of the magnetic fields B created by the current to be measured Is. When the frequency of the current to be measured Is is low and the influence of the propagation delay of the induced voltage that is induced in the coil 101 can be ignored, the output voltage Vout represented by the following equation (1) is output to the output terminal that is connected to the output end y of the coil 101. Here, the constant α is determined from the number of turns, the cross-sectional area, and the like of the coil 101.

$$\text{Vout} = \alpha \frac{d\text{Is}}{dt} \quad (1)$$

According to the above equation (1), the output voltage Vout of the Rogowski coil 10 is proportional to the derivative of the current to be measured Is. Therefore, by integrating with time the output voltage Vout of the Rogowski coil 10, the current to be measured Is can be obtained by the following equation (2).

$$\text{Is} = \frac{1}{\alpha} \int \text{Vout}\, dt \quad (2)$$

FIG. 2 is an equivalent circuit schematically illustrating a configuration of a current measuring device 1 according to the first embodiment. The current measuring device 1 of the present embodiment comprises a Rogowski coil 10 and an integrator 11. Since the Rogowski coil 10 is constituted by an air-core coil, in the equivalent circuit of FIG. 2, the Rogowski coil 10 is illustrated as a self-inductance. In addition, in the equivalent circuit of FIG. 2, an induced voltage that is induced in the Rogowski coil 10 by the current to be measured Is changing with time is illustrated as a pulse generator 12.

The integrator 11 that is connected to the subsequent stage of the Rogowski coil 10 integrates with time the output voltage Vout of the Rogowski coil 10 so as to obtain the current to be measured Is. An analog integrator circuit using an operational amplifier 111 that is an active element, for example, is used as the integrator 11. The output voltage Vs of the integrator 11 illustrated in FIG. 2 can be obtained by the following equation (3), using the electrostatic capacitance value C of the capacitor 112 and the resistance value R of the resistor 113.

$$\text{Vs} = \frac{1}{\text{RC}} \int \text{Vout}\, dt = \frac{\alpha}{\text{RC}} \text{Is} \quad (3)$$

According to the above equation (3), the output voltage Vs of the integrator 11 is proportional to the current to be measured Is. Therefore, by previously obtaining the proportional constant α/(RC), the current to be measured Is can be obtained.

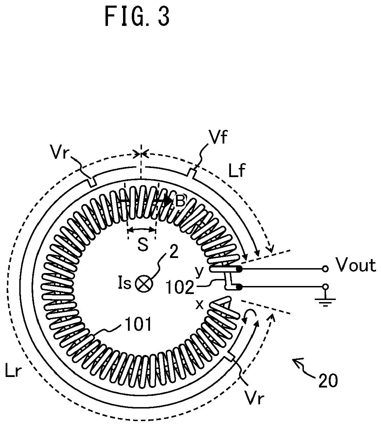

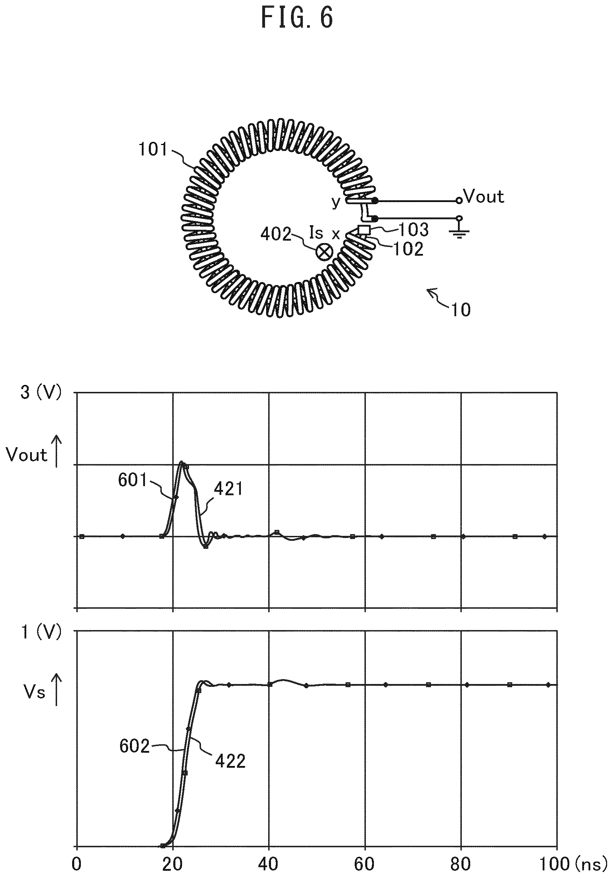

Note that, in order to further widen the frequency band of currents measurable by the Rogowski coil 10, an analog integrator circuit illustrated in FIG. 3 or FIG. 6 of Japanese Patent Application Laid Open No. 2014-89079, for example, may be used instead of the analog integrator circuit illustrated in FIG. 2. Alternatively, a digital integrating circuit may be used as the integrator 11 instead of an analog integrating circuit. In this case, an AD converter (Analog/Digital converter) is connected between the Rogowski coil 10 and the digital integrating circuit. As a result, the limitation of frequency band and the influence of noise due to the analog integrator circuit can be avoided.

Although the configuration of the equivalent circuit of the current measuring device 1 illustrated in FIG. 2 has an integrator 11 that is connected immediately after the Rogowski coil 10, in the actual current measuring device 1, the Rogowski coil 10 and the integrator 11 are preferably connected to each other via a coaxial cable or the like.

Here, in order to show effectiveness of the Rogowski coil 10 of the present embodiment, first, in the Rogowski coil 20 that does not have the impedance matching circuit 103, influence on the measurement accuracy of currents by the propagation delay of the induced voltage that is induced in the coil 101 will be explained.

FIG. 3 is a diagram illustrating a propagation delay of the induced voltage that is induced in the Rogowski coil 20, which is a comparative example. Since the Rogowski coil 20 illustrated in FIG. 3 does not have the impedance matching circuit 103, the coil 101 and the return line 102 are short-circuited at the tip portion x of the coil 101. In order to simplify the following explanation, the coil 101 of the Rogowski coil 20 is divided into a plurality of small sections, and a study will be made on the propagation delay of the induced voltage with attention to an induced voltage that is induced in one of a small section S.

Further, in order to similarly simplify the following explanation, the waveform of the current to be measured Is flowing through the conductor 2 is assumed to be a step waveform. As a result, the waveform of the induced voltage that is induced in the small section S when the current to be measured Is changes with time becomes a pulse waveform. However, note that since the Rogowski coil 10 of the present embodiment can measure any type of waveforms of the current to be measured Is as long as the waveform changes with time, type of waveforms of the current to be measured Is is not limited to the step waveform.

When the magnetic fields B crossing the small section S of the coil 101 illustrated in FIG. 3 change with time, an induced voltage is induced in the small section S of the coil 101. The preceding wave Vf and the delayed wave Vr illustrated in FIG. 3 are waveforms of the induced voltage that are induced at each ends of the small section S of the coil 101 when the return line 102 is used as a reference. The positive and negative polarities of the amplitudes (hereinafter simply referred to as "polarity") of the pulse waveforms of the preceding wave Vf and the delayed wave Vr are opposite to each other. The preceding wave Vf and the delayed wave Vr propagate in opposite directions.

The preceding wave Vf propagating toward the output end y of the coil 101 propagates the distance Lf, and then is output to the output terminal of the Rogowski coil 20 that is connected to the output end y. The time Tf from generation of the preceding wave Vf to output to the output terminal of the Rogowski coil 20 is Tf = Lf / c, using the speed c at which the preceding wave Vf propagates through the coil 101.

On the other hand, the delayed wave Vr propagating toward the tip portion x of the coil 101 propagates the distance Lr, and then is reflected at the boundary between the tip portion x of the coil 101 and the return line 102. After that, the delayed wave Vr propagates a distance Lr + Lf toward the output end y of the coil 101, and then is output to the output terminal of the Rogowski coil 20 that is connected to the output end y. The time Tr from generation of the delayed wave Vr to output to the output terminal of the Rogowski coil 20 is Tr = (2Lr + Lf) / c, using the speed c at which the delayed wave Vr propagates through the coil 101.

Here, since the tip portion x of the coil 101 and the return line 102 are short-circuited at their boundary, the reflection becomes total reflection and the polarity of the delayed wave Vr is inverted at the time of the reflection. Therefore, the polarity of the delayed wave Vr after reflection is, as illustrated in FIG. 3, the same as the polarity of the preceding wave Vf, after being inverted from its original polarity of the delayed wave Vr of before reflection.

As a result, the preceding wave Vf and the delayed wave Vr are overlapped with the same polarity at the output end y of the coil 101 with a time difference Tr-Tf = 2Lr/c due to the propagation delay, and is output as the output voltage Vout from the Rogowski coil 20. If the time width 2Lr/c of the waveform of the output voltage Vout of the Rogowski coil 20 becomes about the same as the period of the current to be measured Is or its transient change time, the frequency band for the current measurement system becomes insufficient. As a result, there is a first problem that the frequency band of currents measurable by the Rogowski coil 20 is limited.

In addition, the spread of the waveform of the output voltage Vout of the Rogowski coil 20 due to the propagation delay of the induced voltage varies depending on the relative position between the Rogowski coil 20 and the current to be measured Is. For this reason, there is a second problem that the measurement result of currents in high frequency region varies depending on the installation condition such as the physical position of the coil 101, and is not stable. This second problem also practically limits the frequency band of currents measurable by the Rogowski coil 20. This second problem will be described below.

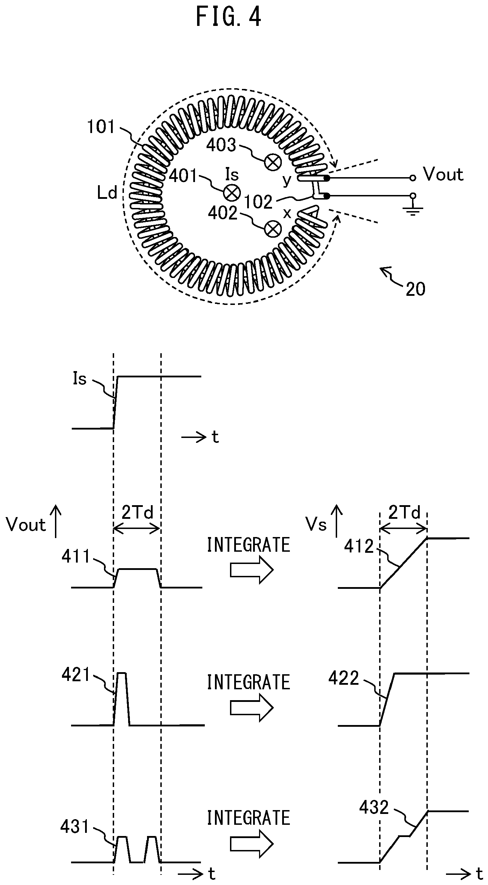

FIG. 4 is a diagram illustrating changes of the output voltage Vout of the Rogowski coil 20 when the relative position between the Rogowski coil 20 and the current to be measured Is is varied, which is a comparative example. FIG. 4 illustrates the output voltage Vout of the Rogowski coil 20 and the output voltage Vs of the integrator 11 when the current to be measured Is having a step waveform flows through the conductor 2 arranged at each of the three relative positions 401 to 403 between the Rogowski coil 20 and the conductor 2. The vertical axis of FIG. 4 represents the magnitude of the output voltage Vout of the Rogowski coil 20 and the output voltage Vs of the integrator 11. The horizontal axis of FIG. 4 represents time.

First, as shown at the relative position 401, a case where the conductor 2 through which the current to be measured Is flows is arranged near the center of the loop of the coil 101 is considered. In this case, induced voltages with substantially the same amplitude and the same phase are induced in every small section from the tip portion x of the coil 101 to the output end y. Thus, the output voltage Vout of the Rogowski coil 20 is the sum of the preceding wave Vf and the delayed wave Vr generated in each small section along the entire the loop of the coil 101.

The waveform 411 represents the change with time of the output voltage Vout of the Rogowski coil 20 when the conductor 2 through which the current to be measured Is flows is arranged at the relative position 401. In addition, the waveform 412 represents the change with time of the output voltage Vs of the integrator 11 when the conductor 2 through which the current to be measured Is flows is arranged at the relative position 401.

As shown by the waveform 411, when the conductor 2 through which the current to be measured Is flows is arranged at the relative position 401, the time width 2Td of the pulse waveform of the output voltage Vout of the Rogowski coil 20 becomes the maximum value of the time difference between the propagation delay of the preceding wave Vf and the propagation delay of the delayed wave Vr. Here, the maximum value of the time difference of the propagation delay between the preceding wave Vf and the delayed wave Vr is 2Ld/c, using the loop length Ld of the coil 101. As a result, as shown by the waveform 412, the step waveform of the output voltage Vs of the integrator 11 becomes a step waveform having a longer change period of 2Td as compared with the waveform of the current to be measured Is. Therefore, the frequency band of currents measurable by the Rogowski coil 20 is limited.

Next, as shown at the relative position 402, a case where the conductor 2 through which the current to be measured Is flows is arranged near the tip portion x of the loop of the coil 101 is considered. In this case, induced voltages that are induced in the coil 101 concentrate on the tip portion x of the coil 101. Thus, the output voltage Vout of the Rogowski coil 20 becomes substantially the same as an overlapped waveform of the preceding wave Vf and the delayed wave Vr generated in the small section at the tip portion x of the coil 101 with the same polarity.

The waveform 421 represents the change with time of the output voltage Vout of the Rogowski coil 20 when the conductor 2 through which the current to be measured Is flows is arranged at the relative position 402. In addition, the waveform 422 represents the change with time of the output voltage Vs of the integrator 11 when the conductor 2 through which the current to be measured Is flows is arranged at the relative position 402.

When the conductor 2 through which the current to be measured Is flows is arranged at the relative position 402, the time difference between the propagation delay of the preceding wave Vf and the propagation delay of the delayed wave Vr becomes almost zero. Thus, the output voltage Vout of the Rogowski coil 20 is the same as an overlapped waveform of the preceding wave Vf and the delayed wave Vr generated in the small section of the tip portion x of the coil 101 with the same polarity and without a time difference due to propagation delay.

Therefore, as shown by the waveform 421, when the conductor 2 through which the current to be measured Is flows is arranged at the relative position 402, the time width of the pulse waveform of the output voltage Vout of the Rogowski coil 20 is hardly affected by the propagation delay of the induced voltage. As a result, as shown by the waveform 422, the waveform of the output voltage Vs of the integrator 11 substantially reproduces the waveform of the current to be measured Is. In this case, the frequency band of currents measurable by the Rogowski coil 20 is hardly limited by the propagation delay of the induced voltage.

Next, as shown at the relative position 403, a case where the conductor 2 through which the current to be measured Is flows is arranged near the output end y of the loop of the coil 101 is considered. In this case, induced voltages that are induced in the coil 101 concentrate on the output end y of the coil 101. Thus, the output voltage Vout of the Rogowski coil 20 becomes substantially the same as an overlapped waveform of the preceding wave Vf and the delayed wave Vr generated in the small section at the output end y of the coil 101 with the same polarity and with a time difference due to propagation delay.

The waveform 431 represents the change with time of the output voltage Vout of the Rogowski coil 20 when the conductor 2 through which the current to be measured Is flows is arranged at the relative position 403. In addition, the waveform 432 represents the change with time of the output voltage Vs of the integrator 11 when the conductor 2 through which the current to be measured Is flows is arranged at the relative position 403.

As shown by the waveform 431, when the conductor 2 through which the current to be measured Is flows is arranged at the relative position 403, the waveform of the output voltage Vout of the Rogowski coil 20 has two pulse waveforms of the preceding wave Vf and the delayed wave Vr which are overlapped with the same polarity. The time width 2Td of the waveform 431 is the time difference 2Ld/c of the propagation delay between the preceding wave Vf and the delayed wave Vr. As a result, as shown by the waveform 432, the waveform of the output voltage Vs of the integrator 11 becomes a step waveform having two change periods. Thus, the frequency band of currents measurable by the Rogowski coil 20 is limited.

As described above, if the relative position between the Rogowski coil 20 and the current to be measured Is varies, the waveforms 411, 421 and 431 of the output voltage Vout of the Rogowski coil 20 that does not have the impedance matching circuit 103 vary greatly with respect to the waveform of the current to be measured Is. Therefore, in the Rogowski coil 20 that does not have the impedance matching circuit 103, the measurement result of the currents in high frequency region is not stable, and the frequency band of currents measurable by the Rogowski coil 20 is actually limited.

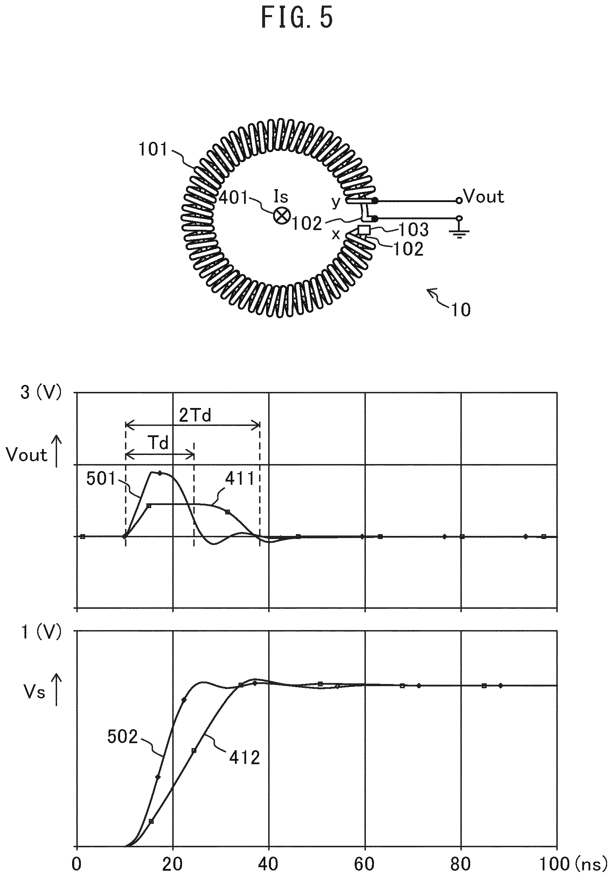

FIGS. 5 to 7 are diagrams illustrating changes of the output voltage Vout of the Rogowski coil 10 according to the first embodiment when the relative position between the Rogowski coil 10 and the current to be measured Is is varied. The Rogowski coil 10 of the present embodiment comprises the impedance matching circuit 103. FIGS. 5 to 7 illustrate simulated results of the output voltage Vout of the Rogowski coil 10 and the voltage Vs obtained by integrating the voltage Vout when the position of the conductor 2 through which the current to be measured Is flows is at one of three relative positions 401 to 403 illustrated in FIG. 4, respectively. Here, it is assumed that the waveform of the current to be measured Is flowing through the conductor 2 is a step waveform with a rising time of 5 (ns).

In the simulations, the transmission line of the Rogowski coil 10 is modeled as a distributed constant line with LC circuits of 20 elements connected in series, and transient analysis was performed using a SPICE simulator. It is assumed that the inductance L of the Rogowski coil 10 is 10 ($\mu$H), and the electrostatic capacitance C between the coil 101 and the return line 102 is 10 (pF). In this case, the characteristic impedance of the coil 101 as the transmission line is $\sqrt{(L/C)} = 1000(\Omega)$, and the propagation delay time is $\sqrt{(LC)} = 10$(ns).

In FIG. 5, a waveform 501 of the output voltage Vout of the Rogowski coil 10, and a waveform 502 of the voltage Vs obtained by integrating the output voltage Vout, when the conductor 2 through which the current to be measured Is flows is arranged near the center of the loop of the coil 101 as shown at the relative position 401, are shown. In addition, in FIG. 5, a waveform 411 of the output voltage Vout of the Rogowski coil 20 without impedance matching, and a waveform 412 of the voltage Vs obtained by integrating calculation of the output voltage Vout are shown for comparison.

The waveform 501 of the output voltage Vout of the Rogowski coil 10 has a pulse width Td that is shorter than and about half of the waveform 411 of the output voltage Vout of the Rogowski coil 20 which is not impedance matched. Similarly, the waveform 502 of the voltage Vs obtained by integrating the output voltage Vout has signal change period Td that is shorter than and about half of the waveform 412 of the voltage Vs obtained by integrating the output voltage Vout without impedance matching. These are because the impedance matching circuit 103 suppressed signal reflections at the boundary between the tip portion x of the coil 101 and the return line 102.

In FIG. 6, a waveform 601 of the output voltage Vout of the Rogowski coil 10, and a waveform 602 of the voltage Vs obtained by integrating the output voltage Vout, when the conductor 2 through which the current to be measured Is flows is arranged near the tip portion x of the loop of the coil 101 as shown at the relative position 402, are shown. In addition, in FIG. 6, a waveform 421 of the output voltage Vout of the Rogowski coil 20 without impedance matching, and a waveform 422 of the voltage Vs obtained by integrating calculation of the output voltage Vout are shown for comparison.

The waveform 601 of the output voltage Vout of the Rogowski coil 10 is substantially the same as the waveform 421 of the output voltage Vout of the Rogowski coil 20 which is not impedance matched. Similarly, the waveform 602 of the voltage Vs obtained by integrating the output voltage Vout is substantially the same as the waveform 422 of the voltage Vs obtained by integrating the output voltage Vout without impedance matching. These are because the time difference between the propagation delay of the preceding wave Vf and the propagation delay of the delayed wave Vr was almost zero at the tip portion x of the coil 101, and the influence of the propagation delay of the induced voltage was originally small.

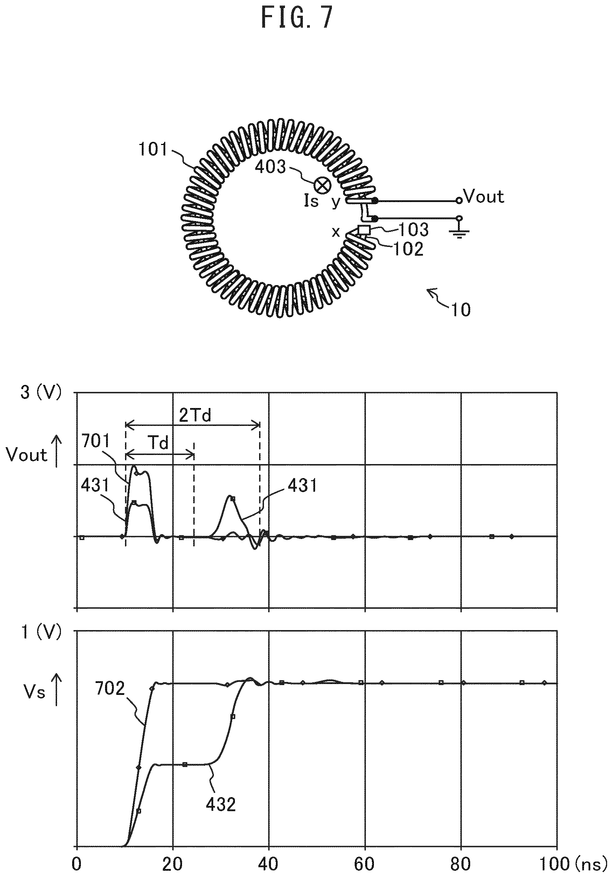

In FIG. 7, a waveform 701 of the output voltage Vout of the Rogowski coil 10, and a waveform 702 of the voltage Vs obtained by integrating the output voltage Vout, when the conductor 2 through which the current to be measured Is flows is arranged near the output end y of the coil 101 as shown at the relative position 403, are shown. In addition, in FIG. 7, a waveform 431 of the output voltage Vout of the Rogowski coil 20 without impedance matching, and a waveform 432 of the voltage Vs obtained by integrating the output voltage Vout are shown for comparison.

The waveform 701 of the output voltage Vout of the Rogowski coil 10 is different from the waveform 431 of the output voltage Vout of the Rogowski coil 20 which is not impedance matched, in that the pulse waveform of the reflection wave has been removed and has only one pulse waveform. Similarly, the waveform 702 of the voltage Vs obtained by integrating the output voltage Vout is different from the waveform 432 of the voltage Vs obtained by integrating the output voltage Vout without impedance matching, in that the waveform has only one change period, not two change periods. These are because the impedance matching circuit 103 suppressed signal reflections at the boundary between the tip portion x of the coil 101 and the return line 102.

In addition, the waveform 701 of the output voltage Vout and the waveform 702 of the voltage Vs illustrated in FIG. 7 are substantially the same as the waveform 601 of the output voltage Vout and the waveform 602 of the voltage Vs illustrated in FIG. 6, respectively. This contrasts with the waveforms 431 and 432 illustrated in FIG. 7 without impedance matching, being significantly different from the waveforms 421 and 422 illustrated in FIG. 6, respectively.

As described above, since the spread of the waveform of the output voltage Vout of the Rogowski coil 10 with the impedance matching circuit 103 of the present embodiment does not depend on the relative position between the Rogowski coil 10 and the current to be measured Is, the influence of the propagation delay of the induced voltage can be suppressed. As a result, the time width of the waveform of the output voltage Vout of the Rogowski coil 10 becomes about half of the time width of the output voltage Vout of the Rogowski coil 20 which is not impedance matched, and the frequency band of currents measurable by the Rogowski coil 10 is approximately doubled in bandwidth.

As described above, a Rogowski coil of the present embodiment comprises: a coil formed by winding a wire in a solenoid shape; and a return line penetrating the inside of the coil from a tip portion, which is one end of the coil, to an output end, which is the other end of the coil. Further, the Rogowski coil of the present embodiment comprises an impedance matching circuit connected between the tip portion of the coil and the return line, having an impedance matched with the characteristic impedance of the coil.

According to such a configuration of the Rogowski coil, signal reflections at the boundary between the tip portion of the coil and the return line can be suppressed. As a result, since the output voltage waveform of the Rogowski coil is suppressed from spreading due to the influence of signal reflections, and therefore the frequency band of currents measurable by the Rogowski coil becomes wider, the above first problem that the widening of the bandwidth of currents measurable by the Rogowski coil is limited can be solved.

In addition, according to the configuration of the Rogowski coil of the present embodiment, the output voltage waveform of the Rogowski coil due to the propagation delay of the induced voltage does not significantly vary depending on the relative position between the Rogowski coil and the current to be measured. Therefore, the above second problem that the measurement result of currents in high frequency region varies and is not stable depending on the installation condition such as the physical position of the coil can also be solved.

(Second Embodiment)

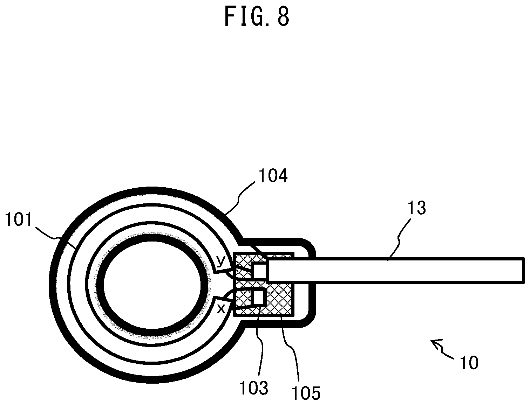

FIG. 8 is a diagram schematically illustrating a configuration of a Rogowski coil 10 according to a second embodiment. The Rogowski coil 10 of the present embodiment comprises a shield 104 arranged to cover the coil 101, as illustrated in FIG.8. Since a coupling capacitance is generated between the coil 101 and the shield 104, the impedance of the coil 101 as a transmission line varies. Therefore, the impedance of the impedance matching circuit 103 of the present embodiment is matched with the characteristic impedance of the coil 101 considering the variation of the electrostatic capacitance due to the arrangement of the shield 104. Here, the shield 104 may, for example, be a shield case with conductor layers having an electrostatic shield effect. Since the other things are the same as described in the first embodiment, the things different from the first embodiment will be described below.

The coil 101 illustrated in FIG. 8 is curved in a circular shape to form a loop, and is housed in the shield 104 together with the impedance matching circuit 103 mounted on the substrate 105. The output end y of the coil 101 is connected to an integrator (not illustrated) via the coaxial cable 13. Here, the length of the connecting portion between the coil 101, the return line 102 and the impedance matching circuit 103, and the length of the connecting portion between the coaxial cable 13 and the coil 101 are preferably designed to be short so as not to be affected by ambient magnetic field noise. In addition, the area of the loop formed by these wirings is preferably designed to be small so as not to be penetrated by the magnetic fields.

Since the Rogowski coil 10 uses the induced voltages that are induced by magnetic fields B generated by the current to be measured Is changing with time, when peripheral electric fields changing with time are overlapped on the induced voltage, the current measurement accuracy decreases. The higher the frequency of the noise signal is, the stronger the capacitive coupling between the electric field noise source and the coil 101 is. Therefore, in order to take advantage of the wide frequency band characteristic of the Rogowski coil 10, the connecting portion between the coil 101, the return line 102, and the impedance matching circuit 103, and the connecting portion between the coaxial cable 13 and the coil 101 are preferably covered with a shield 104 which shields electric fields. Further, the coaxial cable 13 is preferably a double shielded product, where the shield layers are separated from each other.

The characteristic impedance and the propagation delay time of the coil 101 as the transmission line are determined depending on the capacitance between the coil 101 and the shield 104, in addition to the inductance of the coil 101 and the capacitance between the coil 101 and the return line 102. Therefore, for example, if a shield case is used as the shield 104 and the size of the shield case is downsized, the capacitance between the conductor layer of the shield case and the coil 101 increases, and the characteristic impedance of the Rogowski coil 10 and the propagation delay time vary. Therefore, the structure of the coil 101 and the shield 104 is preferably designed so that the characteristic impedance and the propagation delay time of the Rogowski coil 10 are optimized according to the magnitude and frequency of the current to be measured.

In addition, the shield 104 is preferably arranged such that the electrostatic capacitance between the shield 104 and the coil 101 is uniform along the loop of the coil 101. For example, if the shield 104 is close to the coil 101 only at a part of the loop of the coil 101, the characteristic impedance of the coil 101 varies at the close position and impedance matching becomes difficult.

Although the shield 104 illustrated in FIG. 8 has an effect of shielding electric field noise from the surroundings, it may cause stray capacitance to the impedance matching circuit 103. The influence of the stray capacitance can be suppressed by constituting the impedance matching circuit 103 with circuit elements such as an inductance and a capacitance, instead of constituting the impedance matching circuit 103 with only a resistance element. For that purpose, the impedance matching circuit 103 may be constituted with combined circuit elements such that the impedance matching circuit 103, which includes the coupling capacitance with the shield 104, matches the characteristic impedance of the coil 101, which includes the coupling capacitance with the shield 104.

As described above, since the Rogowski coil 10 of the present embodiment has the shield 104, electric field noise from the surroundings can be shielded and the frequency band of measurable currents can be widened. It has been common to use a current transformer for conventional measurement of currents in a high frequency region exceeding 50 MHz. However, the current transformer has a problem that the magnetic flux will be saturated with a large current, and in order to avoid the saturation of the magnetic flux, the device becomes large in size. The Rogowski coil 10 of the present embodiment substitute such current transformers and can measure high frequency currents to be measured Is.

As described above, the Rogowski coil of the present embodiment further comprises a shield that covers the coil, wherein the impedance of the impedance matching circuit is matched with the characteristic impedance of the coil considering the capacitance due to the addition of the shield. According to such a configuration of the Rogowski coil, electric field noise from the surroundings can be shielded and the frequency band of currents measurable by the Rogowski coil can be widened.

(Third Embodiment)

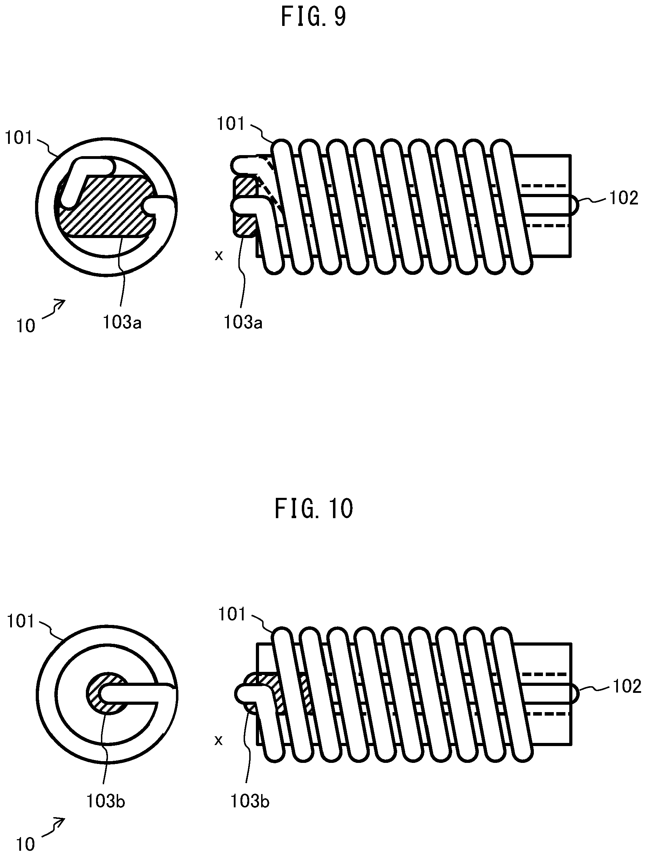

FIGS. 9 and 10 are diagrams schematically illustrating configurations of a Rogowski coil 10 according to a third embodiment. FIGS. 9 and 10 illustrate arrangement examples of the impedance matching circuit 103 to connect the impedance matching circuit 103 between the tip portion x of the coil 101 and the return line 102.

The impedance matching circuit 103a illustrated in FIG. 9 is arranged on the end surface of the tip portion x of the coil 101. In addition, the impedance matching circuit 103b illustrated in FIG. 10 is arranged inside the coil 101. Since the other things are the same as described in the first embodiment, the things different from the first embodiment will be described below.

Since the Rogowski coil 10 does not have a magnetic core, the shape of the coil 101 may be changed to circular shape as illustrated in FIG. 1 or changed to linear shape, by configuring the air core coil flexible such that the coil 101 can be curved or extended. In addition, of the tip portion x and the output end y at both ends of the loop of the coil 101, for example, a cover that protects one end may have a convex shape and another cover that protects the other end may have a concave shape so that they can engage to each other. As a result, the cover protecting the tip portion x and the cover protecting the output end portion y can be connected with each other such that the Rogowski coil 10 forms a closed loop, or the cover protecting the tip portion x and the cover protecting the output end portion y can be separated from each other such that the Rogowski coil 10 forms an open loop.

According to such a Rogowski coil 10, the Rogowski coil 10 can temporarily be an open loop so that the conductor 2 through which the current to be measured Is flows can be put into or taken out from the inside the loop of the Rogowski coil 10 through the gap between the tip portion x and the output end y of the coil 101. Therefore, the Rogowski coil 10 has an advantage that the conductor 2 can be arranged inside the loop of the coil 101 without cutting the path of the conductor 2 through which the current to be measured Is flows, as compared with a current transformer or the like where the coil cannot be an open loop.

However, if the impedance matching circuit 103 arranged at the tip portion x of the coil 101 is large in size, the distance between the tip portion x of the coil 101 and the output end y becomes large when the Rogowski coil 10 is a closed loop. As a result, the measurement accuracy of currents measurable by the Rogowski coil 10 decreases. Therefore, the impedance matching circuit 103 arranged at the tip portion x of the coil 101 is preferably small in size.

Therefore, in the Rogowski coil 10 illustrated in FIG. 9, a thin resistance element as an impedance matching circuit 103a is arranged on the end surface of the tip portion x of the coil 101. Further, in the Rogowski coil 10 illustrated in FIG. 10, a cylindrical resistance element as an impedance matching circuit 103b is arranged inside the coil 101. According to such configurations of the Rogowski coil 10, since the tip portion x of the coil 101 remains small in size, and the Rogowski coil 10 has a structure capable of forming an open loop, the frequency band of currents measurable by the Rogowski coil 10 can be further widened.

The Rogowski coil 10 as described above can be used, for example, for applications to measure the current to be measured Is that flows through a large conductor 2 such as an inverter (bus bar) of a train. However, if the cross-sectional area of the conductor 2 is large, since the loop length of the coil 101 becomes long, the propagation delay of the induced voltage in the coil 101 becomes large, and the frequency band measurable by the Rogowski coil 10 is limited. According to the Rogowski coil 10 of the present embodiment, even for such applications, the signal reflections at the boundary between the tip portion x of the coil 101 and the return line 102 are suppressed, and the influence of the propagation delay of the induced voltage can be suppressed.

As described above, the impedance matching circuit of the present embodiment is arranged on the end surface of the tip portion of the coil or inside the coil. According to such a configuration of the Rogowski coil, the Rogowski coil has a structure capable of forming an open loop, and the frequency band of currents measurable by the Rogowski coil can be further widened.

(Other Embodiment)

The above embodiments are merely practical examples of embodiment of the present invention, and the technical scope of the present invention is not limited thereby. The present invention can be carried out in various forms without departing from the technical principles or major features thereof.

The above embodiments can be applied in combination with each other. For example, the shield 104 illustrated in FIG. 8 of the second embodiment may be applied to the configuration of the Rogowski coil 10 illustrated in FIGS. 9 and 10 of the third embodiment. In this case, the shield 104 may be configured to be bendable and extendable together with the coil 101, instead of being configured as a shield case. However, as described above, since the characteristic impedance and the propagation delay time of the Rogowski coil 10 varies due to the arrangement of the shield 104, the capacitance between the shield 104 and the coil 101 is preferably not large.

The Rogowski coil 10 may also be mounted on a substrate. For example, a solenoid-shaped coil 101 can be mounted on a printed circuit board in a loop by using lines and through holes on a multilayer printed circuit board. In this case, the impedance matching circuit 103 can be easily mounted on the substrate on which the coil 101 is mounted.

**Claims**

1.  A Rogowski coil (10) comprising:

    a coil (101) formed by winding a wire in a solenoid shape;
    a return line (102) penetrating the inside of the coil (101) from a tip portion, which is one end of the coil (101), to an output end, which is the other end of the coil (101); and
    an impedance matching circuit (103) having an impedance matched with the characteristic impedance of the coil (101),

    **characterized in that**
    the impedance matching circuit (103) is connected between the tip portion of the coil (101) and the return line (102) such that the coil (101) and the return line (102) are electrically connected at the tip portion of the coil (101) via the impedance matching circuit (103).

2.  The Rogowski coil (10) according to claim 1, wherein the impedance matching circuit (103) is a resistance element.

3.  The Rogowski coil (10) according to claim 1 or 2, further comprising a shield (104) that covers the coil (101), wherein
    the impedance of the impedance matching circuit (103) is matched with the characteristic impedance of the coil (101) considering the capacitance due to the addition of the shield (104).

4.  The Rogowski coil (10) according to claim 3, wherein the impedance matching circuit (103) is covered by the shield (104) together with the coil (101).

5.  The Rogowski coil (10) according to any one of the claims 1 to 4, wherein the impedance matching circuit (103a) is arranged on the end surface of the tip portion of the coil (101).

6.  The Rogowski coil (10) according to any one of the claims 1 to 4, wherein the impedance matching circuit (103b) is arranged inside the coil (101).

7.  A current measuring device (1) comprising:

    the Rogowski coil (10) according to any one of the claims 1 to 6, wherein the coil (101) is arranged to form a loop around a conductor (2) through which the current to be measured (Is) flows; and
    an integrator (11) configured to integrate with time the potential difference that is induced by the current to be measured (Is) changing with time between the output end of the coil (101) and the return line (102), and outputs the measured value (Vs) as the current to be measured (Is).

**Patentansprüche**

1.  Rogowski-Spule (10) mit:

    - einer Spule (101), die durch Wickeln eines Drahtes in eine Spulenform gebildet ist;
    - einer Rückleitung (102), die sich durch das Innere der Spule (101) hindurch von einem Spitzenbereich, bei dem es sich um ein Ende der Spule (101) handelt, zu einem Ausgangsende erstreckt, bei dem es sich um das andere Ende der Spule (101) handelt, und
    - einer Impedanzanpassungsschaltung (103) mit einer auf die charakteristische Impedanz der Spule (101) abgestimmten Impedanz,

    **dadurch gekennzeichnet, dass**
    die Impedanzanpassungsschaltung (103) zwischen dem Spitzenbereich der Spule (101) und die Rückleitung (102) derart eingeschleift ist, dass die Spule (101) und die Rückleitung (102) am Spitzenabschnitt der Spule (101) über die Impedanzanpassungsschaltung (103) elektrisch verbunden sind.

2.  Rogowski-Spule (10) nach Anspruch 1, wobei die Impedanzanpassungsschaltung (103) ein Widerstandselement ist.

3.  Rogowski-Spule (10) nach Anspruch 1 oder 2, weiter umfassend eine Abschirmung (104), welche die Spule (101) abdeckt, wobei die Impedanz der Impedanzanpassungsschaltung (103) auf die charakteristische Impedanz der Spule (101) unter Berücksichtigung der Kapazität aufgrund der Hinzufügung der Abschirmung (104) abgestimmt ist.

4.  Rogowski-Spule (10) nach Anspruch 3, wobei die Impedanzanpassungsschaltung (103) zusammen mit der Spule (101) durch die Abschirmung (104) abgedeckt ist.

5.  Rogowski-Spule (10) nach einem der Ansprüche 1 bis 4, wobei die Impedanzanpassungsschaltung (103a) an der Endfläche des Spitzenabschnitts der Spule (101) angeordnet ist.

6. Rogowski-Spule (10) gemäß einer der Ansprüche 1 bis 4, wobei die Impedanzanpassungsschaltung (103b) im Inneren der Spule (101) angeordnet ist.

7. Strommessvorrichtung (1) mit

- der Rogowski-Spule (10) nach einem der Ansprüche 1 bis 6, wobei die Spule (101) unter Bildung einer Schleife um einen Leiter (2) herum angeordnet ist, durch den der zu messende Strom (Is) fließt; und
- einem Integrator (11), der zum zeitlichen Integrieren der Potenzialdifferenz eingerichtet ist, die durch den sich zeitlich ändernden, zu messenden Strom (Is) zwischen dem Ausgangsende der Spule (101) und der Rückleitung (102) induziert wird, und den gemessenen Wert (Vs) als den zu messenden Strom (Is) ausgibt.

**Revendications**

1. Enroulement de Rogowski (10) comprenant :

un enroulement (101) formé par l'enroulement d'un fil en forme de solénoïde ;
une ligne de retour (102) pénétrant à l'intérieur de l'enroulement (101) d'une partie formant pointe, qui constitue une extrémité de l'enroulement (101), à une extrémité de sortie, qui est l'autre extrémité de l'enroulement (101) ; et
un circuit d'adaptation d'impédance (103) ayant une impédance adaptée à l'impédance caractéristique de l'enroulement (101),

**caractérisé en ce que**
le circuit d'adaptation d'impédance (103) est connecté entre la partie formant pointe de l'enroulement (101) et la ligne de retour (102) de telle sorte que l'enroulement (101) et la ligne de retour (102) soient connectés électriquement à la partie formant pointe de l'enroulement (101) par l'intermédiaire du circuit d'adaptation d'impédance (103).

2. Enroulement de Rogowski (10) selon la revendication 1, dans lequel le circuit d'adaptation d'impédance (103) est un élément de résistance.

3. Enroulement de Rogowski (10) selon la revendication 1 ou 2, comprenant en outre un blindage (104) qui recouvre l'enroulement (101), l'impédance du circuit d'adaptation d'impédance (103) étant adaptée à l'impédance caractéristique de l'enroulement (101) en tenant compte de la capacité due à l'ajout du blindage (104).

4. Enroulement de Rogowski (10) selon la revendication 3, dans lequel le circuit d'adaptation d'impédance (103) est recouvert par le blindage (104) ainsi que par l'enroulement (101).

5. Enroulement de Rogowski (10) selon l'une quelconque des revendications 1 à 4, dans lequel le circuit d'adaptation d'impédance (103a) est agencé sur la surface extrême de la partie formant pointe de l'enroulement (101).

6. Enroulement de Rogowski (10) selon l'une quelconque des revendications 1 à 4, dans lequel le circuit d'adaptation d'impédance (103b) est agencé à l'intérieur de l'enroulement (101).

7. Dispositif de mesure de courant (1) comprenant :

l'enroulement de Rogowski (10) selon l'une quelconque des revendications 1 à 6, l'enroulement (101) étant agencé de manière à former une boucle autour d'un conducteur (2) à travers lequel circule le courant à mesurer (Is) ; et
un intégrateur (11) configuré pour intégrer dans le temps la différence de potentiel qui est induite par le courant à mesurer (Is) variant dans le temps entre l'extrémité de sortie de l'enroulement (101) et la ligne de retour (102), et pour délivrer en sortie la valeur mesurée (Vs) en tant que courant à mesurer (Is).

FIG. 1

FIG. 2

FIG. 3

# FIG. 4

# FIG. 5

# FIG. 6

# FIG. 7

FIG. 8

# FIG. 9

# FIG. 10

**EP 3 761 042 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1073908 A1
- EP 1073908 A
- US 6614218 B1
- JP 2014089079 A

**Non-patent literature cited in the description**

- **J. COOPER.** On the High-Frequency Response of a Rogowski Coil. *J. Nucl. Energy, Pt. C,* 01 September 1963, 285